(19) Europäisches Patentamt / European Patent Office / Office européen des brevets

(11) **EP 4 624 269 A1**

(12) **EUROPEAN PATENT APPLICATION**
published in accordance with Art. 153(4) EPC

(43) Date of publication:
01.10.2025 Bulletin 2025/40

(21) Application number: 23907698.7

(22) Date of filing: 19.12.2023

(51) International Patent Classification (IPC):
*B60R 16/033* (2006.01)  *B60R 16/023* (2006.01)
*H01M 10/48* (2006.01)  *H02J 7/00* (2006.01)

(52) Cooperative Patent Classification (CPC):
H02J 7/0048; G01R 31/382; G01R 31/392;
G01R 31/396; H02J 7/00032; H02J 7/0014

(86) International application number:
PCT/KR2023/021025

(87) International publication number:
WO 2024/136415 (27.06.2024 Gazette 2024/26)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 19.12.2022  KR 20220178734
13.12.2023  KR 20230180590

(71) Applicant: LG Energy Solution, Ltd.
Seoul 07335 (KR)

(72) Inventor: CHOI, Jung Hwan
Daejeon 34122 (KR)

(74) Representative: Plasseraud IP
104 Rue de Richelieu
CS92104
75080 Paris Cedex 02 (FR)

(54) **BATTERY MANAGEMENT DEVICE AND OPERATION METHOD THEREOF**

(57) Aspects of the disclosed technology include techniques, mechanism, and a battery management apparatus for diagnosing battery cells that may experience under-voltage. The battery management apparatus may determine a cumulative balancing time of each battery cell of a plurality of battery cells included in a battery pack. The battery management system may determine whether the battery pack is abnormal by comparing a median of the cumulative balancing times of each of the plurality of battery cells with a first reference time. The battery management apparatus may identify at least one under-voltage battery cell of the plurality of battery cells by comparing the cumulative balancing time of each of the plurality of battery cells with a second reference time when the median exceeds the first reference time.

FIG.2

**Description**

**[TECHNICAL FIELD]**

CROSS-REFERENCE TO RELATED APPLICATION

The present application claims the priority to a Korean patent application No. 10-2023-0180590 filed on December 13, 2023 and a Korean patent application No. 10-2022-0178734 filed on December 19, 2022, the entire disclosures of which are hereby incorporated by reference.

TECHNICAL FIELD

Embodiments disclosed herein relate to a battery management apparatus and an operating method thereof.

**[BACKGROUND ART]**

An electric vehicle is supplied with electricity from outside to charge a battery cell, and then a motor is driven by a voltage charged in the battery cell to obtain power. The battery cell of the electric vehicle is manufactured by receiving an electrode assembly in a battery case and injecting an electrolyte into the battery case.

The battery cell may experience an under-voltage failure in which the voltage of the battery cell is reduced to a predetermined level or lower for reasons such as a foreign substance, folding of a separator, internal short-circuit, or the like. The under-voltage battery cell might not have a self-discharge event where a voltage is reduced in initial production thereof, thus being difficult to detect in the production process. When an internal short-circuit occurs as the vehicle uses the battery after mounting the under-voltage battery cell on the vehicle, a voltage change may occur due to a self-discharge current of the battery. However, it may be difficult for a battery management apparatus to separately measure a self-discharge rate of the under-voltage battery cell and, thus, to diagnose the under-voltage battery cell.

[DISCLOSURE]

[TECHNICAL PROBLEM]

Aspects of the disclosed technology include a battery management apparatus and a method in which an under-voltage battery cell is diagnosed early by using a cumulative balancing time of a battery cell, thereby securing stability and reliability of battery energy.

Technical problems of the examples disclosed herein are not limited to the above-described technical problems, and other unmentioned technical problems would be clearly understood by one of ordinary skill in the art from the following description.

**[TECHNICAL SOLUTION]**

A battery management apparatus according to some embodiments disclosed herein includes a data management unit configured to calculate a cumulative balancing time of each of a plurality of battery cells included in a battery pack and a controller configured to determine whether the battery pack is abnormal by comparing a median of the cumulative balancing time of each of the plurality of battery cells with a first reference time and diagnose at least one of the plurality of battery cells by comparing the cumulative balancing time of each of the plurality of battery cells with a second reference time when the median exceeds the first reference time.

According to some examples, the data management apparatus may further include a memory, in which the data management unit is further configured to record the cumulative balancing time in the memory by accumulating a balancing time of each of the plurality of battery cells.

According to some examples, the controller may be further configured to calculate a first balancing time by dividing a capacity deviation of the plurality of battery cells by a balancing capacity of the plurality of battery cells, calculate a second balancing time by multiplying a number of days of use of the battery pack by a value obtained by dividing a state of charge (SoC) deviation of the plurality of battery cells by the balancing capacity of the plurality of battery cells, and calculate a first reference time by multiplying a first threshold value by a reference balancing time obtained by summing the first balancing time and the second balancing time.

According to some examples, the controller may be further configured to determine the battery pack as an abnormal battery pack when the median exceeds the first reference time.

According to some examples, the controller may be further configured to list the plurality of battery cells based on a cumulative balancing time and extract a plurality of battery cells within a threshold rank, calculate a standard deviation of a cumulative balancing time of each of the plurality of battery cells within the threshold rank, and calculate the second reference time by subtracting, from the median, a value obtained by multiplying a second threshold value by the standard deviation.

According to some examples, the controller may be further configured to diagnose the battery cell when a cumulative balancing time of any one of the plurality of battery cells is less than the second reference time.

An operating method of a battery management apparatus according to some examples disclosed herein includes calculating a cumulative balancing time of each of a plurality of battery cells included in a battery pack, calculating a median of the cumulative balancing time of each of the plurality of battery cells, determining whether the battery pack is abnormal by comparing the median with a first reference time, and diagnosing at least one of the plurality of battery cells by comparing the cumulative balancing time of each of the plurality of battery cells with a second reference time when the median exceeds the first reference time.

According to some examples, the calculating of the cumulative balancing time of each of the plurality of battery cells included in the battery pack may include recording the cumulative balancing time in the memory by accumulating a balancing time of each of the plurality of battery cells.

According to some examples, the determining of whether the battery pack is abnormal by comparing the median with the first reference time may include calculating a first balancing time by dividing a capacity deviation of the plurality of battery cells by a balancing capacity of the plurality of battery cells, calculating a second balancing time by multiplying a number of days of use of the battery pack by a value obtained by dividing a state of charge (SoC) deviation of the plurality of battery cells by the balancing capacity of the plurality of battery cells, and calculating a first reference time by multiplying a first threshold value by a reference balancing time obtained by summing the first balancing time and the second balancing time.

According to some examples, the determining of whether the battery pack is abnormal by comparing the median with the first reference time may include determining the battery pack as an abnormal battery pack when the median exceeds the first reference time.

According to some examples, the diagnosing of at least one of the plurality of battery cells by comparing the cumulative balancing time of each of the plurality of battery cells with a second reference time when the median exceeds the first reference time may include listing the plurality of battery cells based on a cumulative balancing time and extracting a plurality of battery cells within a threshold rank, calculating a standard deviation of a cumulative balancing time of each of the plurality of battery cells within the threshold rank, and calculating the second reference time by subtracting, from the median, a value obtained by multiplying a second threshold value by the standard deviation.

According to some examples, the diagnosing of at least one of the plurality of battery cells by comparing the cumulative balancing time of each of the plurality of battery cells with the second reference time when the median exceeds the first reference time may include diagnosing the battery cell when a cumulative balancing time of any one of the plurality of battery cells is less than the second reference time.

One aspect of the disclosure provides for a battery management apparatus comprising: one or more processors configured to: compare a median of a cumulative balancing time of each of a plurality of battery cells included in a battery pack to a first reference time; determine, based on the comparison, whether the battery pack is abnormal, wherein the battery pack is abnormal when the median of the cumulative balancing time of each of the plurality of battery cells exceeds the first reference time; and based on determining the battery pack is abnormal, identify at least one abnormal battery cell of the plurality of battery cells based on determining the cumulative balancing time of the at least one abnormal battery cell is less than a second reference time; and output a signal to a target device wherein the signal identifies the at least one abnormal battery cell.

According to some examples, the one or more processors are further configured to calculate the cumulative balancing time of each of the plurality of battery cells.

According to some examples, the battery management apparatus further comprises a memory, wherein the one or more processors are further configured to store the cumulative balancing time in the memory by accumulating a balancing time of each battery cell of the plurality of battery cells.

According to some examples, the one or more processors are further configured to: calculate a first balancing time by dividing a capacity deviation of the plurality of battery cells by a balancing capacity of the plurality of battery cells; calculate a second balancing time by multiplying a number of days of use of the battery pack by a value obtained by dividing a state of charge (SoC) deviation of the plurality of battery cells by the balancing capacity of the plurality of battery cells; and calculate a first reference time by multiplying a first threshold value by a reference balancing time obtained by summing the first balancing time and the second balancing time.

According to some examples, the one or more processors are further configured to: list the plurality of battery cells based on a cumulative balancing time and extract a plurality of battery cells having respective cumulative balancing times within a threshold rank; calculate a standard deviation of a cumulative balancing time of each of the plurality of battery cells having respective cumulative balancing times within the threshold rank; and calculate the second reference time by subtracting, from the median, a value obtained by multiplying a second threshold value by the standard deviation.

A different aspect of the disclosure provides for a method of battery management, the method comprising: retrieving, from a memory, a cumulative balancing time of each battery cell of a plurality of battery cells included in a battery pack; determining a median of the cumulative balancing time of each of the plurality of battery cells; determining whether the battery pack is abnormal by comparing the median with a first reference time; based on determining the median exceeds the first reference time, comparing the cumulative balancing time of each of the plurality of battery cells with a second reference time; identifying , based on the comparison to the second reference time, at least one abnormal battery cell of the plurality of battery cells; and outputting a signal to a target device wherein the signal identifies the at least one abnormal battery cell.

According to some examples, determining the median of the cumulative balancing time comprises recording the cumulative balancing time in the memory by accumulating a balancing time of each of the plurality of battery cells.

According to some examples, determining whether the battery pack is abnormal comprises: calculating a first balancing time by dividing a capacity deviation of the plurality of battery cells by a balancing capacity of the plurality of battery cells; calculating a second balancing time by multiplying a number of days of use of the battery pack by a value obtained by dividing a state of charge (SoC) deviation of the plurality of battery cells by the balancing capacity of the plurality of battery cells; and calculating a first reference time by multiplying a first threshold value by a reference balancing time obtained by summing the first balancing time and the second balancing time.

According to some examples, determining whether the battery pack is abnormal comprises determining the battery pack as an abnormal battery pack when the median exceeds the first reference time.

According to some examples, identifying the at least one abnormal battery cell comprises: listing the plurality of battery cells based on a cumulative balancing time and extracting a plurality of battery cells within a threshold rank; calculating a standard deviation of a cumulative balancing time of each of the plurality of battery cells within the threshold rank; and calculating the second reference time by subtracting, from the median, a value obtained by multiplying a second threshold value by the standard deviation.

According to some examples, identifying the at least one abnormal battery cell comprises diagnosing, when a cumulative balancing time of a first battery cell of the plurality of battery cells is less than the second reference time, a first battery cell as an abnormal battery cell.

A different aspect of the disclosure may provide for a non-transitory computer readable storage medium storing instructions that, when executed by one or more processors, cause the one or more processors to: compare a median of a cumulative balancing time of each of a plurality of battery cells included in a battery pack to a first reference time; determine, based on the comparison, whether the battery pack is abnormal, wherein the battery pack is abnormal when the median of the cumulative balancing time of each of the plurality of battery cells exceeds the first reference time; based on determining the battery pack is abnormal, identify at least one abnormal battery cell of the plurality of battery cells based on determining the cumulative balancing time of the at least one abnormal battery cell is less than a second reference time; and output a signal to a target device wherein the signal identifies the at least one abnormal battery cell.

According to some examples, the one or more processors are further configured to calculate the cumulative balancing time of each of the plurality of battery cells.

According to some examples, the one or more processors are further configured to: calculate a first balancing time by dividing a capacity deviation of the plurality of battery cells by a balancing capacity of the plurality of battery cells; calculate a second balancing time by multiplying a number of days of use of the battery pack by a value obtained by dividing a state of charge (SoC) deviation of the plurality of battery cells by the balancing capacity of the plurality of battery cells; and calculate a first reference time by multiplying a first threshold value by a reference balancing time obtained by summing the first balancing time and the second balancing time.

According to some examples, determining whether the battery pack is abnormal comprises determining the battery pack as an abnormal battery pack when the median exceeds the first reference time.

According to some examples, the one or more processors are further configured to: list the plurality of battery cells based on a cumulative balancing time and extract a plurality of battery cells having respective cumulative balancing times within a threshold rank; calculate a standard deviation of a cumulative balancing time of each of the plurality of battery cells having respective cumulative balancing times within the threshold rank; and calculate the second reference time by subtracting, from the median, a value obtained by multiplying a second threshold value by the standard deviation.

According to some examples, identifying the at least one abnormal battery cell comprises diagnosing, when a cumulative balancing time of a first battery cell of the plurality of battery cells is less than the second reference time, the first battery cell as an abnormal battery cell.

According to some examples, the instructions further cause the one or more processors to perform: recording the cumulative balancing time in the memory by accumulating a balancing time of each of the plurality of battery cells.

**[ADVANTAGEOUS EFFECTS]**

With the battery management apparatus and the operating method thereof according to some emobidments disclosed herein, an under-voltage battery cell may be diagnosed early by using a cumulative balancing time of a battery cell, thereby securing stability and reliability of battery energy. Early diagnosis may occur before under-voltage abnormal battery cells lower the performance and safety of the battery pack.

**[DESCRIPTION OF DRAWINGS]**

FIG. 1 illustrates an example battery pack, in accordance with aspects of the disclosure.

FIG. 2 is a block diagram of an example configuration of a battery management apparatus, in accordance with aspects of the disclosure.

FIG. 3 is an example graph showing a cumulative balancing time of a battery cell, in accordance with aspects of the disclosure.

FIGS. 4A-C are example tables showing state of charge (SoC) data of a battery cell, in accordance with aspects of the disclosure.

FIG. 5A is an example table showing characteristic data of a battery cell, in accordance with aspects of the disclosure.

FIG. 5B is an example table showing use data of a battery cell, in accordance with aspects of the disclosure.

FIG. 6 is an example diagnosis of an under-voltage battery cell of a controller, in accordance with aspects of the disclosure.

FIG. 7 is a flow diagram for an example method of diagnosing an under-voltage battery cell, in accordance with aspects of the disclosure.

FIG. 8 is a block diagram of an example computing system for performing an operating method of diagnosing an under-voltage battery cell, in accordance with aspects of the disclosure.

**[MODE FOR INVENTION]**

Examples disclosed herein are described in detail with reference to the drawings. In adding reference numerals to components of each drawing, it should be noted that the same components are given the same reference numerals even though they are indicated in different drawings.

It should be understood that phrases such as "A or B", "at least one of A and B", "at least one of A or B", "A, B or C", "at least one of A, B and C", and "at least one of A, B, or C" may include any one of items listed together in the corresponding phrase among those phrases, or all possible combinations of the items. Terms such as "first", "second", "firstly", "secondly", "A", "B", "(a)" or "(b)" may simply be used to distinguish a corresponding component from other corresponding components, and unless specifically stated to the contrary, do not limit the corresponding components in other respects (e.g., importance or order).

It should be appreciated that embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

It should be understood that if a certain (e.g., first) element is referred to as being "linked", "combined", "accessed", or "connected" or "coupled" with or without the terms "functionally" or "communicatively" to another (e.g., second) component, it means that the certain component can be connected to the other component directly (e.g., in a wired manner), wirelessly, or through a third component. When a portion is referred to as being "connected" to another portion, it is not limited to the case that they are "directly connected", but it also includes the case where they are "indirectly connected" with another element being interposed between them. When a portion is referred to as "comprising" or "including" any element, it means that the portion may include other elements further, without excluding other elements, unless specifically stated otherwise.

A method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

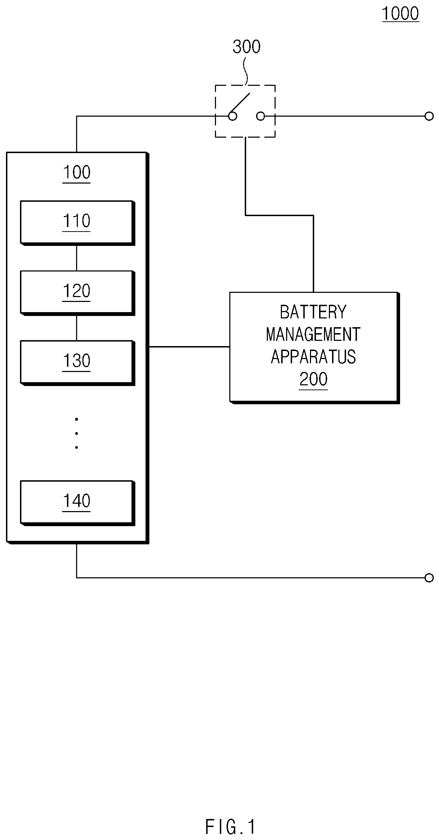

FIG. 1 illustrates an example battery pack, in accordance with aspects of the disclosure.

Referring to FIG. 1, battery pack 1000 may include battery module 100, battery management apparatus 200, and relay 300. In some embodiments, battery module 100 may be a battery cell, and in such embodiments, battery pack 1000 may have a cell-to-pack structure.

Battery module 100 may include a plurality of battery cells 110, 120, 130, and 140. While four battery cells are illustrated in FIG. 1, battery module 100 may include more or fewer than four battery cells. Four battery cells are illustrated for example purposes only, not limitation.

Battery module 100 may supply power to a target device (not shown). To this end, battery module 100 may be electrically connected to the target device. The target device may include an electrical, electronic, or mechanical device that operates by receiving power from battery pack 1000 including the plurality of battery cells 110, 120, 130, and 140. In some instances, the target device may be, for example, an electric vehicle (EV) or an energy storage system (ESS), but the present disclosure is not limited thereto.

The plurality of battery cells 110, 120, 130, and 140, each of which may be a basic unit of a battery available by charging and discharging electrical energy, may be a lithium ion (Li-ion) battery, an Li-ion polymer battery, a nickel-cadmium (Ni-Cd) battery, a nickel hydrogen (Ni-MH) battery, or the like. While FIG. 1 illustrates a single battery module within battery pack 1000, more than one battery module may be included in battery pack 1000.

Battery pack 1000 may include battery management apparatus 200, discussed in detail below. Battery management apparatus 200 may be configured as a hardware component, a software program, an application-specific integrated circuit (ASIC), etc., or any combination thereof. Battery management apparatus 200 may manage and/or control a state and/or an operation of battery module 100. For example, battery management apparatus 200 may manage and/or control the states and/or operations of the plurality of battery cells 110, 120, 130, and 140 included in battery module 100. Battery management apparatus 200 may charge and/or discharge battery module 100.

Battery management apparatus 200 may control an operation of relay 300. For example, battery management apparatus 200 may short-circuit relay 300 to supply power to the target device. Battery management apparatus 200 may short-circuit relay 300 when a charging device is connected to battery pack 1000.

In addition, battery management apparatus 200 may monitor a voltage, a current, a temperature, or the like of battery module 100 and/or each of the plurality of battery cells 110, 120, 130, and 140 included in battery module 100. A sensor or various measurement modules for the monitoring performed by the battery management apparatus 200, which are not shown, may be installed in battery module 100, a charging/discharging path, any position of battery module 100, or the like. Battery management apparatus 200 may calculate a parameter indicating a state of battery module 100, such as a state of charge (SoC) based on measurement values such as monitored voltage, current, or temperature.

Battery management apparatus 200 may include a balancing circuit (not shown). The balancing circuit may include a resistor and a switching element connected to both ends of each of the plurality of battery cells 110, 120, 130, and 140. Battery management apparatus 200 may transmit a control signal to the balancing circuit to turn the switching element ON/OFF. Battery management apparatus 200 may control the connection of the resistor through the ON/OFF of the switching element of the balancing circuit to consume a balancing current of the battery cell and to lower a voltage, thereby adjusting a voltage of each battery cell to be the same.

More specifically, when voltage deviations, such as SoC deviations, among the plurality of battery cells 110, 120, 130, and 140 of the battery management apparatus 200 are greater than or equal to a specific level, the voltages of the plurality of battery cells 110, 120, 130, and 140 may be balanced using the balancing circuit. For example, battery management apparatus 200 may balance a battery cell corresponding to a maximum voltage when a difference between the maximum voltage and a minimum voltage of the plurality of battery cells 110, 120, 130, and 140 is greater than or equal to a preset threshold level. Battery management apparatus 200 may set a target voltage of the battery cell for balancing the battery cell and may transmit a control signal to the balancing circuit to terminate balancing when a voltage of the battery cell reaches the target voltage.

Battery management apparatus 200 may calculate a balancing time of each of the plurality of battery cells 110, 120, 130, and 140. The balancing time may be defined as a time required for balancing the battery cell. For example, battery management apparatus 200 may calculate the balancing time based on an SoC, a battery capacity, and a balancing efficiency of each of the plurality of battery cells 110, 120, 130, and 140.

Battery management apparatus 200 may diagnose an under-voltage of at least one of the plurality of battery cells 110, 120, 130, and 140 based on a cumulative balancing time of each of the plurality of battery cells 110, 120, 130, and 140. For an under-voltage battery cell, SoC deviations may occur with a normal battery cell due to a self-discharge feature over time. Thus, a battery pack including an under-voltage battery cell may perform balancing on battery cells by using a balancing circuit to address SoC deviations among the battery cells, thereby increasing a cumulative balancing time for the battery pack. In such instances, the balancing circuit may perform balancing on a battery cell having the highest SoC rather than a battery cell having the lowest SoC, such that a balancing time of the under-voltage battery cell included in the battery pack is recorded as being shorter than those of other normal battery cells.

Thus, battery management apparatus 200 may diagnose the under-voltage battery cell when the balancing time of the battery pack including the under-voltage battery cell increases and when the balancing time of the under-voltage battery cell is shorter than those of other normal battery cells. First, battery management apparatus 200 may compare a median of cumulative balancing times of the plurality of battery cells included in the battery pack to a median of a cumulative balancing time of the battery pack including normal battery cells to identify a battery pack suspected of having an abnormal voltage.

Battery management apparatus 200 may identify the battery pack suspected of having an abnormal voltage and may diagnose the under-voltage battery cell by using deviations of cumulative balancing times of the plurality of battery cells included in the battery pack. Battery management apparatus 200 may diagnose the under-voltage battery cell through relative balancing time deviations of the plurality of battery cells included in the battery pack.

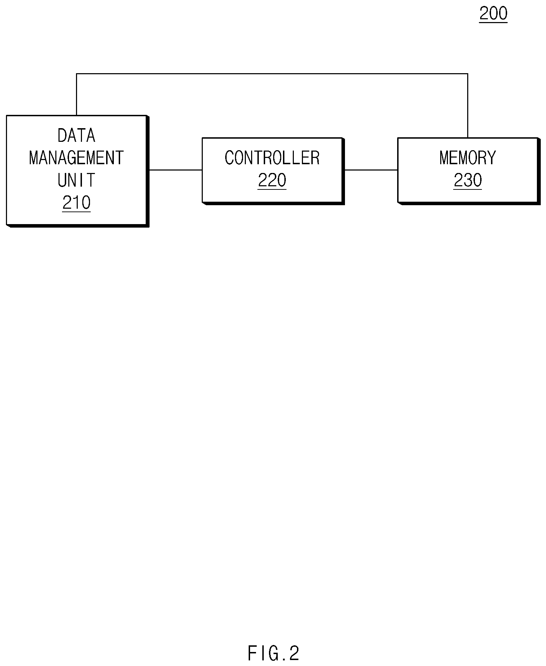

FIG. 2 is a block diagram of an example configuration of a battery management apparatus, in accordance with aspects of the disclosure.

Battery management apparatus 200 may include data management unit 210, controller 220, and memory 230.

Data management unit 210 may record a balancing time of each of the plurality of battery cells 110, 120, 130, and 140 in memory 230. Data management unit 210 may calculate the balancing time of each of the plurality of battery cells 110, 120, 130, and 140 based on an SoC, a battery capacity, and a balancing efficiency of each of the plurality of battery cells 110, 120, 130, and 140. For example, data management unit 210 may calculate the balancing time of each of the plurality of battery cells 110, 120, 130, and 140 by measuring a time for which balancing is performed for each battery cell as the switching element of the balancing circuit connected to each of the battery cells 110, 120, 130, and 140 is turned ON.

Data management unit 210 may record a balancing time of each of the plurality of battery cells 110, 120, 130, and 140 in memory 230 at preset intervals. For example, data management unit 210 may separately store the balancing time of each of the plurality of battery cells 110, 120, 130, and 140 or separately store a balancing time per battery module 100 including the plurality of battery cells 110, 120, 130, and 140.

Data management unit 210 may accumulate the recorded balancing times of each of the plurality of battery cells 110, 120, 130, and 140 in memory 230 to calculate a cumulative balancing time of each of the plurality of battery cells 110, 120, 130, and 140.

Controller 220 may be implemented as a processor for arithmetic processing and instruction execution, an interface circuit for interacting with other components of a target device, a battery pack, or the like. According to some embodiments, the communication scheme of the interface circuit may be a device-to-device communication scheme such as a bus, general purpose input and output (GPIO), serial peripheral interface (SPI), or mobile industry processor interface (MIPI).

Controller 220 may execute instructions implementing processes inside of a target device or a battery pack comprising apparatus 100. Controller 220 may be implemented as a general-purpose microprocessor or an array of multiple logic gates for processing various operations, and may be composed of a single processor or a plurality of processors. For example, controller 220 may be implemented in the form of a microprocessor, a central processing unit (CPU), a graphic processor unit (GPU), an application processor (AP), application specific integrated circuit (ASIC), or combinations thereof.

Memory 230 may accumulate and store the balancing time of each of the plurality of battery cells 110, 120, 130, and 140 measured by data management unit 210. Memory 230 may be implemented in the form of, for example, an electrically erasable programmable read-only memory (EEPROM).

Memory 230 may store various data, instructions, mobile applications, computer programs, and the like. For example, memory 230 may be implemented as nonvolatile memory such as ROM, PROM, EPROM, EEPROM, flash memory, PRAM, MRAM, RRAM, FRAM, etc., or volatile memory such as DRAM, SRAM, SDRAM, PRAM, RRAM, FeRAM, etc. or may be implemented in the form of HDD, SSD, SD, Micro-SD, etc., or a combination thereof.

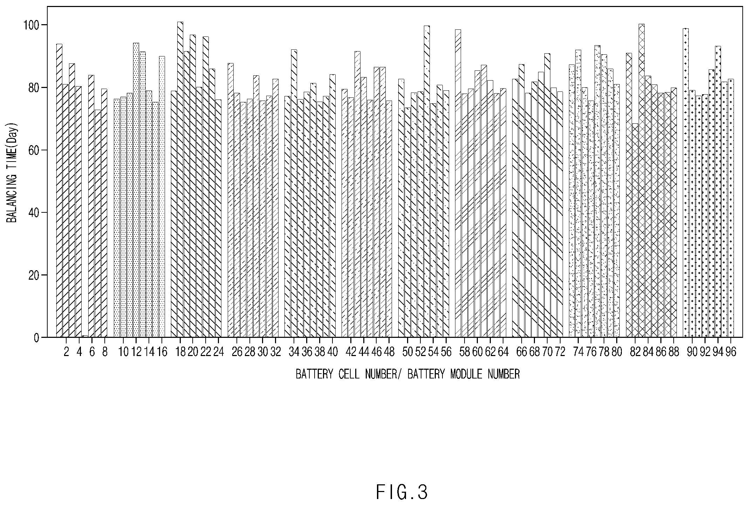

FIG. 3 is an example graph showing a cumulative balancing time of a battery cell, in accordance with aspects of the disclosure.

Referring to FIG. 3, data management unit 210 may separately distinguish and manage a cumulative balancing time for each of the plurality of battery cells 110, 120, 130, and 140 based on a battery cell number of each of the plurality of battery cells 110, 120, 130, and 140. According to some examples, data management unit 210 may separately manage a cumulative balancing time per battery module based on a battery module number of battery module 100 including each of the plurality of battery cells 110, 120, 130, and 140. For example, when battery pack 1000 includes a total of 8 battery modules, each of which includes 12 battery cells, then data management unit 210 may separately manage cumulative balancing times of 96 battery cells based on a battery cell number of each of the 96 battery cells and a battery module number of a battery module including each battery cell.

Controller 220 may diagnose an under-voltage of at least one of the plurality of battery cells 110, 120, 130, and 140 based on a cumulative balancing time of each of the plurality of battery cells 110, 120, 130, and 140. More specifically, controller 220 may determine whether battery pack 1000, including the plurality of battery cells 110, 120, 130, and 140, is abnormal based on the cumulative balancing time of each of the plurality of battery cells 110, 120, 130, and 140. The battery pack may be abnormal when it includes a battery cell having a high self-discharge rate. Whether a self-discharge rate is high may depend on a cumulative balancing time. According to some examples, if a battery pack has an abnormal cell, then the battery pack is abnormal. A normal balancing time may include a balancing time near the median. Based on determining battery pack 1000 is abnormal, controller 220 may diagnose the under-voltage of at least one of the plurality of battery cells 110, 120, 130, and 140 included in the battery pack 1000.

First, controller 220 may calculate a median of the cumulative balancing times of the plurality of battery cells 110, 120, 130, and 140. In some embodiments, the cumulative balancing times of the plurality of battery cells 110-140 may correspond to an average balancing time across the plurality of battery cells 110-140. Controller 220 may use the median (or average) of the cumulative balancing times of the plurality of battery cells 110, 120, 130, and 140 included in battery pack 1000 to determine whether battery pack 1000 is abnormal. The median of the cumulative balancing times may be determined each time cell balancing is performed. Cell balancing may be performed at predetermined time intervals, such as once per day, twice per day, or the like. Further cell balancing may be performed when the battery pack is not in use, such as when the battery pack is OFF.

Controller 220 may determine whether battery pack 1000 is abnormal by comparing the median of the cumulative balancing times of the plurality of battery cells 110, 120, 130, and 140 with a preset first reference time, T1. The preset reference times, also referred to as T values, may be based on patterns observed during previous cell balancing implementations. The T values may remain constant over time, unless one or more conditions trigger a need for new T values. For example, new T values may be needed when a battery pack is aged, when a number of abnormal battery cells within a battery pack is equal to or greater than 2, or the like. T1 may be a criterion for determining whether battery pack 1000 is 'abnormal'. Further, T1 may indicate how different the balancing time of battery pack 1000 is from a balancing time of a normal battery pack.

Controller 220 may identify battery pack 1000 as an abnormal battery pack by determining that a total cumulative balancing time of the plurality of battery cells 110, 120, 130, and 140 included in battery pack 1000 exceeds a predetermined level when the median of the cumulative balancing times of the plurality of battery cells 110, 120, 130, and 140 exceeds the first reference time T1.

Controller 220 may determine the first reference time T1 by using Equation 1 below.

First Reference Time (T1) = Reference Balancing Time (T0) * First Threshold Value                    [Equation 1]

In Equation 1, the reference balancing time, T0, may mean a balancing time of battery pack 1000 that may be obtained when battery pack 1000 is driven normally. That is, the reference balancing time T0 may mean a predicted value of a cumulative balancing time of battery cells included in normal battery pack 1000 that does not include an under-voltage battery cell.

Controller 220 may generate the first reference time T1 by multiplying the reference balancing time T0 by the first threshold value. The first threshold value may be set considering a deviation with respect to a use time per SoC region of battery pack 1000 and an error likely to occur during calculation of a balancing time of a battery cell. In some instances, the use time per SoC region may be based on a comparison of a use time in low SoC and a use time in high SoC, from which the deviation may be determiend. Further, cell balancing may be performed based on estimated cell SoC. Since the estimation may result in cell SoC inaccuracies, the balancing time error is accounted for. For example, controller 220 may set the first threshold value to '3'. Controller 220 may generate the first reference time T1 by multiplying the the reference balancing time T0 by the first threshold value of '3'.

the reference balancing time T0 will be described below with reference to Equation 2.

$$[\text{Equation 2}]$$

$$\text{Reference Balancing Time (T0)} = \text{First Balancing Time (t1)} + \text{Second Balancing Time (t2)}$$

$$\text{First Balancing Time (t1)} = \frac{Battery\ Cell\ Capacity\ Deviation\ (Ah)}{Battery\ Cell\ Balancing\ Capacity\ (\frac{Ah}{day})}$$

$$\text{Second Balancing Time (t2)} = \frac{Battery\ Cell\ SoC\ Deviation\ (\frac{Ah}{day})}{Battery\ Cell\ Balancing\ Capacity\ (\frac{Ah}{day})} *$$

$$Number\ of\ Days\ of\ Use\ of\ Battery\ Pack\ (day)$$

Referring to Equation 2, the reference balancing time T0 may be calculated by adding the first balancing time t1 and the second balancing time t2.

The first balancing time t1 may be a balancing time caused by a capacity deviation of a battery cell and the second balancing time t2 may be a balancing time caused by a self-discharge rate deviation of the battery cell. A factor for causing SoC deviations among battery cells may include a capacity deviation of a battery cell and a self-discharge rate deviation of the battery cell. Controller 220 may calculate each of the first balancing time t1 caused by the capacity deviation of the battery cell and the second balancing time t2 caused by the self-discharge rate deviation of the battery cell.

The first balancing time t1 may be a deviation caused during manufacturing of the battery cell and may be changed according to a use pattern of the battery. Controller 220 may calculate the first balancing time t1 by dividing capacity deviations of the plurality of battery cells 110, 120, 130, and 140 by balancing capacities of the plurality of battery cells 110, 120, 130, and 140.

The second balancing time t2 may be an SoC deviation caused by a self-discharge rate deviation of a battery cell and may be caused by a discharge rate of a battery cell decreasing for a specific time. Controller 220 may calculate the second balancing time t2 by multiplying the number of use days of battery pack 1000 by a value obtained by dividing the SoC deviations caused by the self-discharge rates of the plurality of battery cells 110, 120, 130, and 140 by the balancing capacities of the plurality of battery cells 110, 120, 130, and 140. The SoC deviations caused by the self-discharge rates of the plurality of battery cells 110, 120, 130, and 140 may change according to average temperatures of the plurality of battery cells 110, 120, 130, and 140 and initial SoC's of the plurality of battery cells 110, 120, 130, and 140.

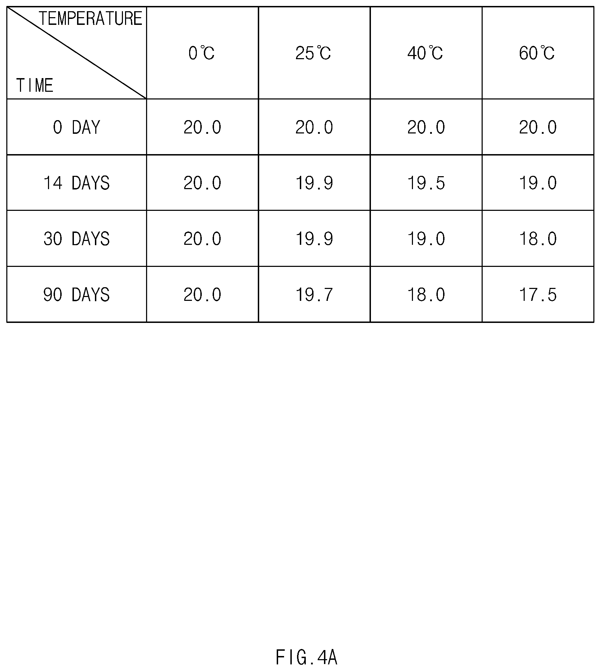

FIGS. 4A-C are example tables showing SoC data of a battery cell, in accordance with aspects of the disclosure.

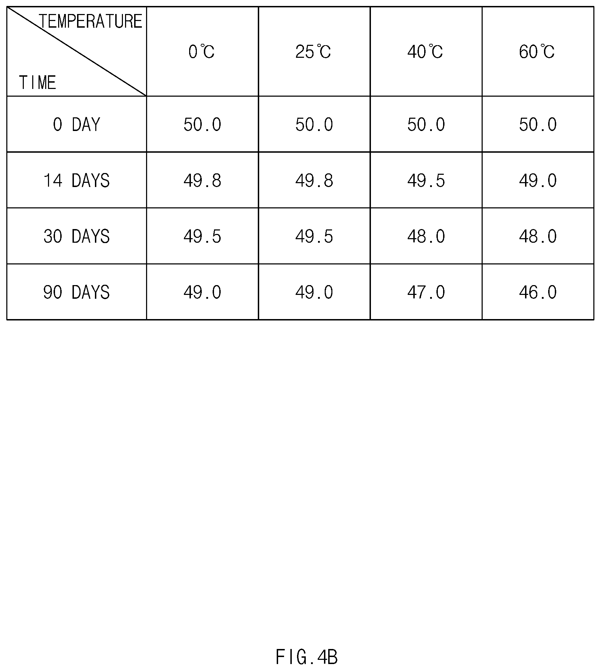

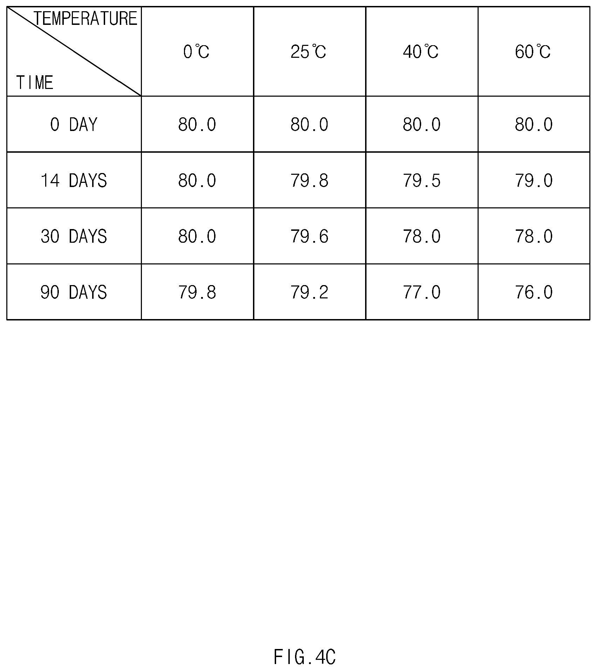

FIG. 4A shows a table of an SoC based on temperatures and times of a battery cell when an initial SoC of the battery cell is 20 %. FIG. 4B shows a table of an SoC based on temperatures and times of a battery cell when an initial SoC of the battery cell is 50 %. FIG. 4C shows a table of an SoC based on temperatures and times of a battery cell when an initial SoC of the battery cell is 80 %.

Controller 220 may calculate the second balancing time t2 by using FIGS. 4A to 4C. Controller 220 may calculate an SoC deviation caused by a self-discharge rate of a battery cell with respect to an initial SoC and an average temperature of the battery cell by using FIGS. 4A to 4C. Controller 220 may calculate the second balancing time t2 by using the SoC deviation caused by the self-discharge rate of the battery cell. For example, when an initial SoC of a battery cell is 20 % and an average temperature of the battery cell is 60 °C, controller 220 may use an SoC of 17.5 % of the battery cell after 90 days later by using the table shown in FIG. 4A.

Controller 220 may calculate the reference balancing time T0 by using battery characteristic data including a capacity, a capacity deviation, a balancing current, and a balancing capacity of the battery cell corresponding to characteristics of the plurality of battery cells 110, 120, 130, and 140. Battery cell capacity may indicate the capacity of a battery cell. Battery cell capacity deviation may indicate a deviation between a capacity of a battery cell and a median of capacities of all battery cells. Balancing current may measure the current flowing through a cell when the cell balancing is performed. Battery cell balancing capacity may indicate an amount of cell capacity that a battery cell gives to other cells in a day.

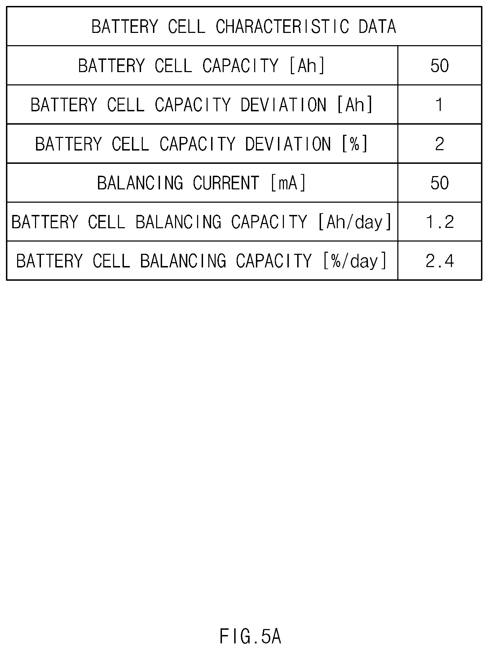

FIG. 5A is an example table showing characteristic data of a battery cell, in accordance with aspects of the disclosure.

Referring to FIG. 5A, controller 220 may calculate the first balancing time t1 and the second balancing time t2 by using capacities, capacity deviations, balancing currents, and balancing capacity data of the plurality of battery cells 110, 120, 130, and 140 corresponding to characteristics of the plurality of battery cells 110, 120, 130, and 140.

For example, with reference to FIG. 5A, controller 220 may obtain '1 Ah' as capacity deviations of the plurality of battery cells 110, 120, 130, and 140 and '1.2 Ah/day' as balancing capacities of the plurality of battery cells 110, 120, 130, and 140. Controller 220 may divide the capacity deviations of the plurality of battery cells 110, 120, 130, and 140 by the balancing capacities to calculate the first balancing time t1 as '0.83 days'.

For example, with reference to FIG. 5A, controller 220 may obtain '1.2 Ah/day' as the balancing capacities of the plurality of battery cells 110, 120, 130, and 140 and use the same to calculate the second balancing time t2 of the plurality of battery cells 110, 120, 130, and 140.

Controller 220 may also calculate the reference balancing time T0 by using battery cell use data including the number of use days of the battery pack, an average temperature of the battery cell, an average SoC, a self-discharge rate of the battery cell, a self-discharge rate deviation, and an SoC deviation caused by a self-discharge rate generated according to use of the plurality of battery cells 110, 120, 130, and 140.

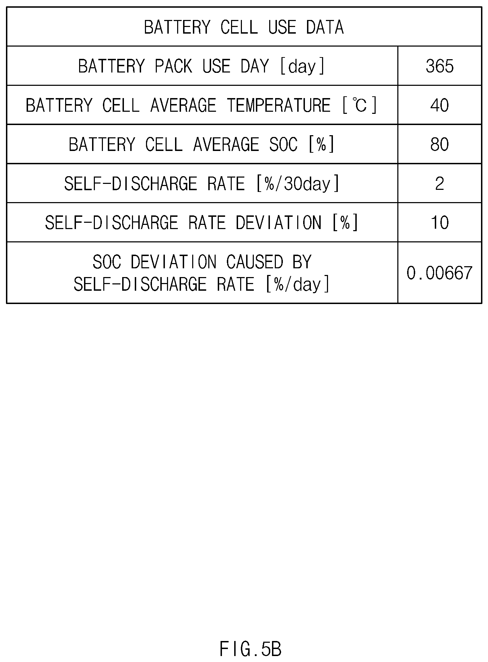

FIG. 5B is an example table showing use data of a battery cell, in accordance with aspects of the disclosure. Battery pack use day may indicate the number of days per year that the battery pack is in use. Battery cell average temperature may indicate an average temperature of a plurality of battery cells during a preset period (year, month, day, etc.). Battery cell average SoC may indicate an average SoC of battery cells during a preset period (year, month, day, etc.). Self-discharge rate may indicate an amount of self-discharge of a battery cell during 30 days. Self-discharge rate deviation may indicate a deviation between a self-discharge of a battery cell and a median of self-discharges of all battery cells. SoC deviation caused by self-discharge rate may indicate an amount of SoC a battery cell deviated by self-discharge during a day.

For example, referring to FIG. 5B, controller 220 may obtain '365 days' as the number of use days of battery pack 1000, obtain '0.00667' as an SoC deviation caused by a self-discharge rate of the plurality of battery cells 110, 120, 130, and 140, and calculate the second balancing time t2 as '1.01389 days" by multiplying the number of use days of battery pack 1000 by a value obtained by dividing the SoC deviation caused by the self-discharge rate by the balancing capacity of the plurality of battery cells 110, 120, 130, and 140 obtained through FIG. 5A.

Controller 220 may calculate the first balancing time t1 and the second balancing time t2, respectively, and add the first balancing time t1 and the second balancing time t2 to calculate the reference balancing time T0. For example, controller 220 may calculate the first balancing time t1 as "0.83 day" and the second balancing time t2 as "1.01389 day", and add the first balancing time t1 and the second balancing time t2 to calculate the reference balancing time T0 as "1.84722 day".

Controller 220 may also generate the first reference time T1 by multiplying the generated reference balancing time T0 by the first threshold value. For example, controller 220 may calculate the reference balancing time T0 as "1.84722 day" and multiply the reference balancing time T0 by the first threshold value of "3" to calculate the first reference time T1 as "5.54167" days.

Controller 220 may determine battery pack 1000 is abnormal when a median of the cumulative balancing times of the plurality of battery cells 110, 120, 130, and 140 exceeds the first reference time T1. For example, when controller 220 calculates the first reference time T1 as '5.54167 days' and calculates the median of the cumulative balancing times of the plurality of battery cells 110, 120, 130, and 140 as '51.6826 days', then controller 220 may determine battery pack 1000 is abnormal.

In some embodiments, based on determining battery pack 1000 is abnormal, controller 220 may transmit an output signal to an external device or the target device. The signal may identify at least one battery cell of the plurality of battery cells 110-140 that may experience under-voltage. The external device or the target device may use the received signal to balance the plurality of battery cells 110-140. In some instances, the external device or target device may be a vehicle, such as an electric vehicle (EV), a hybrid electric vehicle (HEV), an electric bicycle (e-bike), or the like. The signal may inform the driver of the vehicle of the detected battery issue and may restrict further battery performance.

For example, when controller 220 calculates the first reference time T1 as '5.54167 days' and calculates the median of the cumulative balancing times of the plurality of battery cells 110, 120, 130, and 140 as '3.88300 days', then controller 220 may determine e battery pack 1000 is normal.

When the median of the cumulative balancing times of the plurality of battery cells 110, 120, 130, and 140 exceeds the first reference time **T1,** controller 220 may compare a cumulative balancing time of each of the plurality of battery cells 110, 120, 130, and 140 with the second reference time T2 and may diagnose at least one of the plurality of battery cells 110, 120, 130, and 140.

According to some emobidments, controller 220 may list the plurality of battery cells 110, 120, 130, and 140 based on their cumulative balancing times and may extract a battery cell within a threshold rank from among the plurality of battery cells 110, 120, 130, and 140. The threshold may be determined experimentally and may exclude potential balancing time outliers. The threshold may be changed, if necessary, when performance of finding abnormal cells is lowered.

For example, controller 220 may list the plurality of battery cells 110, 120, 130, and 140 based on their cumulative balancing times and extract battery cells corresponding to top 10 % and bottom 10%. As described above, battery module 100 may include more or fewer than the four battery cells 110, 120, 130, and 140. As such, the battery cells that may be extracted may be additional battery cells not illustrated in FIG. 1. For example, in embodiments where battery pack 1000 includes 8 battery modules, each of which includes 12 battery cells, controller 220 may list each of the 96 battery cells and the corresponding balancing times. Of the 96 battery cells, controller 220 may extract the balancing cells within the top 10% of balancing times as well the balancing cells within the bottom 10% of balancing times. In some embodiments, more or less than 96 battery cells may be included in battery pack 1000. 96 battery cells are discussed herein by way of example only, not limitation.

Controller 220 may calculate a standard deviation $\sigma$ of a cumulative balancing time of each battery cell within a threshold rank. For example, controller 220 may list the plurality of battery cells 110, 120, 130, and 140 based on their cumulative balancing times and calculate, as '0.72210', a standard deviation $\sigma$ of the cumulative balancing times of a remaining battery cells excluding the top 10% cells and the bottom 10% cells, which may include additional battery cells that are not illustrated in battery module 100 of FIG. 1.

Controller 220 may calculate a second reference time T2 by using the median and the standard deviation $\sigma$ of the cumulative balancing times of the plurality of battery cells 110, 120, 130, and 140. The second reference time T2 may be a criterion for diagnosing a battery cell as an under-voltage battery cell. The second reference time T2 may indicate how different the balancing time of the battery cell is from a balancing time of a normal battery pack.

Controller 220 may generate the second reference time T2 based on Equation 3 below.

Second Reference Time (T2) = Median - Standard Deviation (σ) * Second Threshold Value [Equation 3]

Controller 220 may calculate the second reference time T2 by subtracting a product of the standard deviation σ and a second threshold value from the median of the cumulative balancing times of the plurality of battery cells 110, 120, 130, and 140.

For example, controller 220 may calculate the median of the cumulative balancing times of the plurality of battery cells 110, 120, 130, and 140 as '51.6826 days', calculate the standard deviation σ of the cumulative balancing times of the plurality of battery cells 110, 120, 130, and 140 as '0.72210 days', and subtract a product, '8.9693 days', of the standard deviation σ and the second threshold value of' '10', from the median, thereby calculating the second reference time T2 as '42.7133days'.

When the cumulative balancing time of any one of the plurality of battery cells 110, 120, 130, and 140 is less than the second reference time T2, controller 220 may diagnose the battery cell as an under-voltage battery cell. In such instances, controller 220 may transmit an output signal to the external device or the target device. The signal may identify at least one battery cell that may experience under-voltage. The external device or the target device may use the received signal to balance the plurality of battery cells. In some instances, the external device or target device may be a vehicle, such as an electric vehicle (EV), a hybrid electric vehicle (HEV), an electric bicycle (e-bike), or the like. The signal may inform the driver of the vehicle of the detected battery issue and may restrict further battery performance.

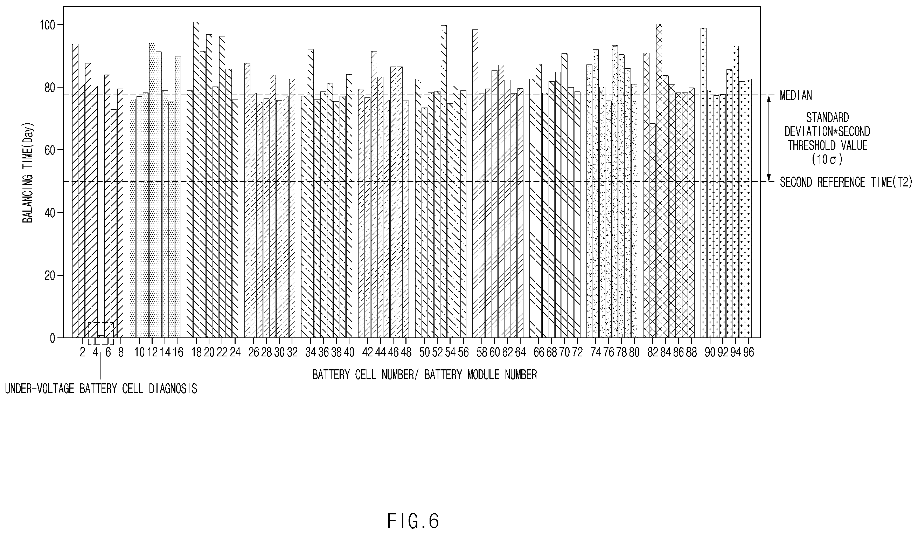

FIG. 6 is an example diagnosis of an under-voltage battery cell of a controller, in accordance with aspects of the disclosure.

Controller 220 may calculate the second reference time T2 by subtracting a product of the standard deviation σ and a second threshold value from the median of the cumulative balancing times of the plurality of battery cells 110, 120, 130, and 140. Controller 220 may compare the second reference time T2 to the cumulative balancing times and, based on determining the cumulative balancing times are less than the second reference time T2, controller 220 may diagnose the battery cell as an under-voltage battery cell.

Controller 220 may identify the under-voltage battery cell among the plurality of battery cells 110, 120, 130, and 140 by comparing differences in the cumulative balancing times among the plurality of battery cells 110, 120, 130, and 140.

Battery management apparatus 200, according to some emobidments disclosed herein, may perform an early diagnosis of an under-voltage battery cell by using a cumulative balancing time of a battery cell, thereby securing stability and reliability of battery energy.

In addition, battery management apparatus 200 may quickly and conveniently diagnose the under-voltage battery cell because there is no need to remove a battery to diagnose a battery cell having a high self-discharge rate in a state of the battery mounted on a vehicle.

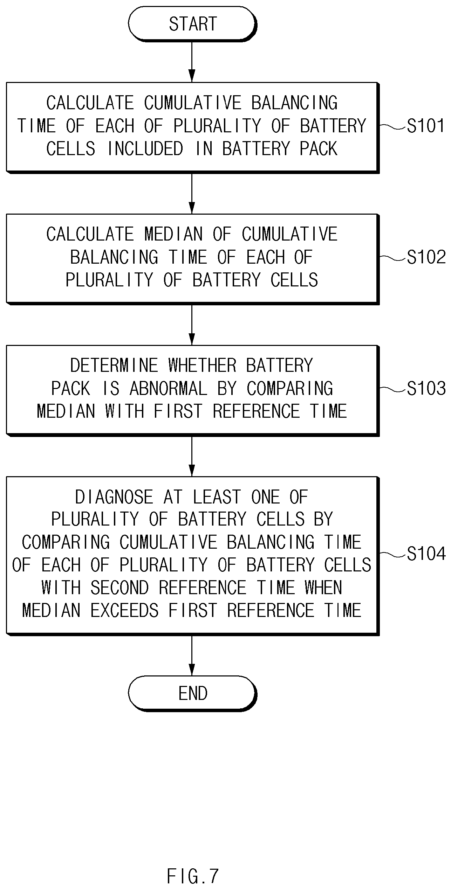

FIG. 7 is a flow diagram for an example method of diagnosing an under-voltage battery cell, in accordance with aspects of the disclosure.

Referring to FIG. 7 ,the operating method may be performed by battery management apparatus 200 and may include operation S101 of calculating a cumulative balancing time of each of the plurality of battery cells 110, 120, 130, and 140 included in battery pack 1000, operation S102 of calculating a median of the cumulative balancing time of each of the plurality of battery cells 110, 120, 130, and 140, operation S103 of determining whether battery pack 1000 is abnormal by comparing the median with the first reference time T1, and operation S104 of diagnosing at least one of the plurality of battery cells 110, 120, 130, and 140 by comparing the cumulative balancing time of each of the plurality of battery cells 110, 120, 130, and 140 with the second reference time T2.

At block S101, data management unit 210 may record a balancing time of each battery cell of the plurality of battery cells 110, 120, 130, and 140 in memory 230. Data management unit 210 may calculate the balancing time of each of the plurality of battery cells 110, 120, 130, and 140 based on an SoC, a battery capacity, and a balancing efficiency of each of the plurality of battery cells 110, 120, 130, and 140. For example, data management unit 210 may calculate the balancing time of each of the plurality of battery cells 110, 120, 130, and 140 by measuring a time for which balancing is performed for each battery cell as the switching element of the balancing circuit connected to each of the battery cells 110, 120, 130, and 140 is turned ON.

Data management unit 210 may store the balancing times of each of the plurality of battery cells 110, 120, 130, and 140 in memory 230 at preset intervals. The preset intervals may indicate the completion of each iteration of cell balancing. After each completed iteration (or at each preset interval), the balancing times and median thereof may be stored. For example, data management unit 210 may separately store the balancing time of each of the plurality of battery cells 110, 120, 130, and 140 or separately store a balancing time per battery module 100 including the plurality of battery cells 110, 120, 130, and 140.

Data management unit 210 may accumulate the balancing times of each of the plurality of battery cells 110, 120, 130, and 140 and may calculate a cumulative balancing time of each battery cell of the plurality of battery cells 110, 120, 130, and 140. The cumulative balancing time may refer to the balancing time of a single battery cell over time.

Memory 230 may store the balancing time of each of the plurality of battery cells 110, 120, 130, and 140 measured by data management unit 210. Memory 230 may accumulate and store the balancing time of each of the plurality of battery cells 110, 120, 130 and 140 for each battery cell.

Data management unit 210 may separately store a cumulative balancing time for each battery cell based on a battery cell number of each of the plurality of battery cells 110, 120, 130, and 140. According to some emobidments, data management unit 210 may separately manage a cumulative balancing time per battery module based on a battery module number of battery module 100 including each of the plurality of battery cells 110, 120, 130, and 140.

At block S102, controller 220 may calculate a median (or average) of the cumulative balancing times of the plurality of battery cells 110, 120, 130, and 140. Controller 220 may use the median of the cumulative balancing times of the plurality of battery cells 110, 120, 130, and 140 to determine whether battery pack 1000 is abnormal.

At block S103, controller 220 may determine whether battery pack 1000 is abnormal by comparing the median of the cumulative balancing times of the plurality of battery cells 110, 120, 130, and 140 to a preset first reference time T1. The first reference time T1 may indicate how different the balancing time of battery pack 1000 is from a balancing time of a normal battery pack.

Controller 220 may determine battery pack 1000 is an abnormal battery pack based on the cumulative balancing time of the plurality of battery cells 110, 120, 130, and 140 exceeding the preset first reference time T1.

Controller 220 may generate the first reference time T1 by using Equation 4 below.

First Reference Time (T1) = Reference Balancing Time (T0) X First Threshold Value [Equation 4]

In Equation 4, the reference balancing time T0 may mean a balancing time of battery pack 1000 that may be obtained when battery pack 1000 is driven normally. That is, the reference balancing time T0 may mean a predicted value of a cumulative balancing time of battery cells included in the normal battery pack 1000 that does not include an under-voltage battery cell.

Controller 220 may generate the first reference time T1 by multiplying the reference balancing time T0 by a first threshold value. The first threshold value may be set considering a deviation with respect to a use time per SoC region of battery pack 1000 and an error likely to occur during calculation of a balancing time of a battery cell. For example, controller 220 may set the first threshold value to '3'. That is, controller 220 may generate the first reference time T1 that is three times the reference balancing time T0 by multiplying the reference balancing time T0 by the first threshold value of '3'.

The reference balancing time T0 will be described below with reference to Equation 5.

$$[\text{Equation 5}]$$

$$\text{Reference Balancing Time (T0)} = \text{First Balancing Time (t1)} + \text{Second Balancing Time (t2)}$$

$$\text{First Balancing Time (t1)} = \frac{Battery\ Cell\ Capacity\ Deviation\ (Ah)}{Battery\ Cell\ Balancing\ Capacity\ (\frac{Ah}{day})}$$

$$\text{Second Balancing Time (t2)} = \frac{Battery\ Cell\ SoC\ Deviation\ (\frac{Ah}{day})}{Battery\ Cell\ Balancing\ Capacity\ (\frac{Ah}{day})} *$$

$$Number\ of\ Days\ of\ Use\ of\ Battery\ Pack\ (day)$$

Referring to Equation 5, the reference balancing time T0 may be calculated by adding the first balancing time t1 and the second balancing time t2.

The first balancing time t1 may be a balancing time caused by a capacity deviation of a battery cell, and the second balancing time t2 may be a balancing time caused by a self-discharge rate deviation of the battery cell. A factor for causing SoC deviations among battery cells may include a capacity deviation of a battery cell and a self-discharge rate deviation of the battery cell.

Controller 220 may calculate each of the first balancing time t1 caused by the capacity deviation of the battery cell and the second balancing time t2 caused by the self-discharge rate deviation of the battery cell. The first balancing time t1 may be a deviation caused during manufacturing of the battery cell and may be changed according to a use pattern of the battery.

Controller 220 may calculate the first balancing time t1 by dividing capacity deviations of the plurality of battery cells 110, 120, 130, and 140 by balancing capacities of the plurality of battery cells 110, 120, 130, and 140. The second balancing time t2 may be an SoC deviation caused by a self-discharge rate deviation of a battery cell and may be caused by a discharge rate of a battery cell decreasing for a specific time.

Controller 220 may calculate the second balancing time t2 by multiplying the number of use days of battery pack 1000 by a value obtained by dividing the SoC deviations caused by the self-discharge rates of the plurality of battery cells 110, 120, 130, and 140 by the balancing capacities of the plurality of battery cells 110, 120, 130, and 140.The SoC deviations caused by the self-discharge rates of the plurality of battery cells 110, 120, 130, and 140 may change according to average temperatures of the plurality of battery cells 110, 120, 130, and 140 and initial SoC of the plurality of battery cells 110, 120, 130, and 140.

Controller 220 may calculate the reference balancing time T0 by using battery characteristic data including a capacity, a capacity deviation, a balancing current, and a balancing capacity of the battery cell corresponding to characteristics of the plurality of battery cells 110, 120, 130, and 140 in manufacturing thereof.

Controller 220 may calculate the first balancing time t1 and the second balancing time t2 by using capacities, capacity deviations, balancing currents, and balancing current and balancing capacity data of the plurality of battery cells 110, 120, 130, and 140 corresponding to characteristics of the plurality of battery cells 110, 120, 130, and 140 in manufacturing thereof.

Controller 220 may also calculate the reference balancing time T0 by using battery cell use data including the number of use days of the battery pack, an average temperature of the battery cell, an average SoC and a self-discharge rate of the battery cell, a self-discharge rate deviation, and an SoC deviation caused by a self-discharge rate generated according to use of the plurality of battery cells 110, 120, 130, and 140.

Controller 220 may calculate the first balancing time t1 and the second balancing time t2 by using the number of use days of battery pack 1000, an average temperature of the plurality of battery cells 110, 120, 130, and 140, an average SoC and a self-discharge rate of the battery cell, a self-discharge rate deviation, and an SoC deviation caused by a self-discharge rate of the plurality of battery cells 110, 120, 130, and 140 generated according to use of the plurality of battery cells 110, 120, 130, and 140.

Controller 220 may calculate the first balancing time t1 and the second balancing time t2, respectively, and add the first balancing time t1 and the second balancing time t2 to calculate the reference balancing time T0.

Controller 220 may also generate the first reference time T1 by multiplying the generated reference balancing time T0 by the first threshold value.

Controller 220 may determine battery pack 1000 is abnormal when a median of the cumulative balancing times of the plurality of battery cells 110, 120, 130, and 140 exceeds the first reference time T1. For example, controller 220 may calculate the first reference time T1 as '5.54167 days' and calculate the median of the cumulative balancing times of the plurality of battery cells 110, 120, 130, and 140 as '51.6826 days'. Since the median of the cumulative balancing times is greater than T1, controller 220 may determine battery pack 1000 is abnormal.

For example, controller 220 may calculate the first reference time T1 as '5.54167 days' and calculate the median of the cumulative balancing times of the plurality of battery cells 110, 120, 130, and 140 as '3.88300 days'. Since the median of the cumulative balancing times is less than T1, controller 220 may determine battery pack 1000 is normal.

At block S104, based on determining the median of the cumulative balancing times of the plurality of battery cells 110, 120, 130, and 140 exceeds the first reference time T1, controller 220 may compare a cumulative balancing time of each of the plurality of battery cells 110, 120, 130, and 140 with a second reference time T2 .

According to some emobidments, controller 220 may list the plurality of battery cells 110, 120, 130, and 140 based on their cumulative balancing times and may extract a battery cell within a threshold rank from among the plurality of battery cells 110, 120, 130, and 140. For example, controller 220 may list the plurality of battery cells 110, 120, 130, and 140 based on their cumulative balancing times and may extract the battery cells corresponding to top 10 % and bottom 10%, which may include the plurality of battery cells 110, 120, 130, 140 as well as additional battery cells within battery module 100 (not illustrated in FIG. 1).

Controller 220 may calculate a standard deviation σ of a cumulative balancing time of each battery cell within a threshold rank. For example, controller 220 may list the plurality of battery cells 110, 120, 130, and 140 based on their cumulative balancing times and calculate, as '0.72210', a standard deviation σ of the cumulative balancing times of the plurality of other battery cells 110, 120, 130, and 140 other than the plurality of battery cells 110, 120, 130, and 140 corresponding to top 10 % and bottom 10%. According to some emobidments, 100 battery cells may have 100 cumulative balancing times respectively. The 100 cumulative balancing times may be {0.1, 50.0357, 50.0991, 50.1008, 50.1615, ..., 52.9335, 52.9363, 52.9591, 52.9706, 52.9988} in ascending order. In this example, a battery cell having a cumulative balancing time of 0.1 may be determined as abnormal at a later stage. In order to calculate a standard deviation σ, top 10% and bottom 10% of the 100 battery cells are excluded such that potential outlier values such as 0.1 are not considered. Remaining 80 cumulative balancing times may be {50.3109, 50.3477, 50.3749, 50.4425, 50.4914, ..., 52.6868, 52.7014, 52.7290, 52.7344, 52.7462} in ascending order. For example, a standard deviation σ may be calculated as '0.72210' based on the remaining 80 cumulative balancing times. Meanwhile, if top 10% and bottom 10% of 100 battery cells are not excluded, then a standard deviation $\sigma$ of the 100 battery cells may be '5.54167', since the outlier value such as '0.1' is considered, which leads to inaccurate diagnosis of abnormal cells.

Controller 220 may calculate the second reference time T2 by using the median and the standard deviation $\sigma$ of the cumulative balancing times of the plurality of battery cells 110, 120, 130, and 140. The second reference time T2 may be used to diagnose a battery cell as an under-voltage battery cell. That is, the second reference time T2 may indicate how different the balancing time of the battery cell is from a balancing time of a normal battery pack.

Controller 220 may generate the second reference time T2 based on Equation 6 below.

Second Reference Time (T2) = Median - Standard Deviation ($\sigma$) * Second Threshold Value        [Equation 6]

Controller 220 may calculate the second reference time T2 by subtracting a product of the standard deviation $\sigma$ and a second threshold value from the median of the cumulative balancing times of the plurality of battery cells 110, 120, 130, and 140.

When the cumulative balancing times of any one of the plurality of battery cells 110, 120, 130, and 140 is less than the second reference time T2, controller 220 may diagnose the battery cell as an under-voltage battery cell.

Controller 220 may identify the under-voltage battery cell among the plurality of battery cells 110, 120, 130, and 140 by comparing differences in the cumulative balancing times among the plurality of battery cells 110, 120, 130, and 140.

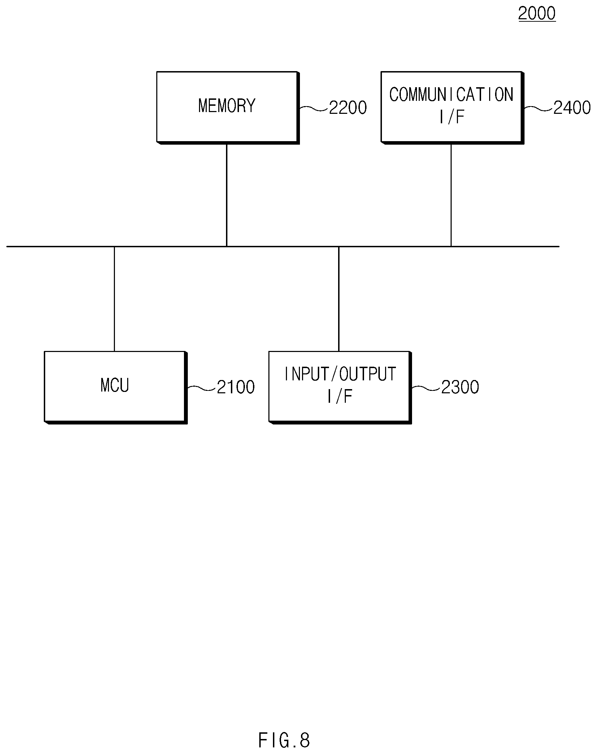

FIG. 8 is a block diagram of an example computing system for performing an operating method of diagnosing an under-voltage battery cell, in accordance with aspects of the disclosure.

Computing system 2000 according to some emobidments disclosed herein may include MCU 2100, memory 2200, input/output I/F 2300, and communication I/F 2400.

MCU 2100 may be a processor that executes various programs (e.g., a battery voltage change amount analysis program, etc.) stored in memory 2200. MCU 2100 may be configured to process various data through these programs, and to perform the above-described functions of battery management apparatus 200 shown in FIG. 1. According to some emobidments, MCU 2100 may perform processing functions associated with data management unit 210 and controller 220 of battery management apparatus 200.

Memory 2200 may store various programs regarding operations of battery management apparatus 200. Moreover, memory 2200 may store operation data of battery management apparatus 200. According to some emobidments, Memory 2200 may perform storing, recording, and/or caching functions associated with controller 220 and memory 230 of battery management apparatus 200.

While a single memory unit is illustrated in FIG. 8, computing system 2000 may include one or more memory units. Memory 2200 may be volatile memory or nonvolatile memory. As volatile memory, memory 2200 may be random access memory (RAM), dynamic RAM (DRAM), static RAM (SRAM), or the like. As nonvolatile memory, memory 2200 may be read only memory (ROM), programmable ROM (PROM), electrically alterable ROM (EAROM), erasable PROM (EPROM), electrically erasable PROM (EEPROM), flash memory, or the like. The above-listed examples of the memory 2200 are merely examples and are not limited thereto.

Input/output I/F 2300 may provide an interface for transmitting and receiving data by connecting an input device (not shown) such as a keyboard, a mouse, a touch panel, or the like and an output device, such as a display (not shown), to MCU 2100.

Communication I/F 2400 may be configured to transmit and receive various data to and from a server. Communication I/F 2400 may include various devices capable of supporting wired or wireless communication. For example, a program for resistance measurement and abnormality diagnosis of the battery cell or various data may be transmitted and received to and from a separately provided external server through communication I/F 2400.

The above description is merely illustrative of the technical idea of the present disclosure, and various modifications and variations will be possible without departing from the present disclosure by those of ordinary skill in the art to which the present disclosure pertains.

Therefore, the embodiments disclosed in the present disclosure are intended for description rather than limitation of the present disclosure and the scope of the present disclosure is not limited by these embodiments.

[DESCRIPTION OF REFERENCE NUMERALS]

1000: Battery Pack
100: Battery Module
110: First Battery Cell
120: Second Battery Cell

130: Third Battery Cell
140: Fourth Battery Cell
200: Battery Management Apparatus
210: Data Management Unit
220: Controller
230: Memory
300: Relay
2000: Computing System
2100: MCU
2200: Memory
2300: Input/Output I/F
2400: Communication I/F
t1: First Balancing Time
t2: Second Balancing Time
T0: Reference Balancing Time
T1: First Reference Time
T2: Second Reference Time

**Claims**

1. A battery management apparatus comprising:
   one or more processors configured to:

   compare a median of a cumulative balancing time of each of a plurality of battery cells included in a battery pack to a first reference time;
   determine, based on the comparison, whether the battery pack is abnormal, wherein the battery pack is abnormal when the median of the cumulative balancing time of each of the plurality of battery cells exceeds the first reference time; and
   based on determining the battery pack is abnormal, identify at least one abnormal battery cell of the plurality of battery cells based on determining the cumulative balancing time of the at least one abnormal battery cell is less than a second reference time; and
   output a signal to a target device wherein the signal identifies the at least one abnormal battery cell.

2. The battery management apparatus of claim 1, wherein the one or more processors are further configured to calculate the cumulative balancing time of each of the plurality of battery cells.

3. The battery management apparatus of claim 1, further comprising a memory,
   wherein the one or more processors are further configured to store the cumulative balancing time in the memory by accumulating a balancing time of each battery cell of the plurality of battery cells.

4. The battery management apparatus of claim 1, wherein the one or more processors are further configured to:

   calculate a first balancing time by dividing a capacity deviation of the plurality of battery cells by a balancing capacity of the plurality of battery cells;
   calculate a second balancing time by multiplying a number of days of use of the battery pack by a value obtained by dividing a state of charge (SoC) deviation of the plurality of battery cells by the balancing capacity of the plurality of battery cells; and
   calculate a first reference time by multiplying a first threshold value to a reference balancing time obtained by summing the first balancing time and the second balancing time.

5. The battery management apparatus of claim 1, wherein the one or more processors are further configured to:

   list the plurality of battery cells based on a cumulative balancing time and extract a plurality of battery cells having respective cumulative balancing times within a threshold rank;
   calculate a standard deviation of a cumulative balancing time of each of the plurality of battery cells having respective cumulative balancing times within the threshold rank; and
   calculate the second reference time by subtracting, from the median, a value obtained by multiplying a second threshold value to the standard deviation.

6. A method of battery management, the method comprising:

retrieving, from a memory, a cumulative balancing time of each battery cell of a plurality of battery cells included in a battery pack;

determining a median of the cumulative balancing time of each of the plurality of battery cells;

determining whether the battery pack is abnormal by comparing the median with a first reference time;

based on determining the median exceeds the first reference time, comparing the cumulative balancing time of each of the plurality of battery cells with a second reference time;

identifying, based on the comparison to the second reference time, at least one abnormal battery cell of the plurality of battery cells; and

outputting a signal to a target device wherein the signal identifies the at least one abnormal battery cell.

7. The method of claim 6, wherein determining the median of the cumulative balancing time comprises:
recording the cumulative balancing time in the memory by accumulating a balancing time of each of the plurality of battery cells.

8. The method of claim 6, wherein determining whether the battery pack is abnormal comprises:

calculating a first balancing time by dividing a capacity deviation of the plurality of battery cells by a balancing capacity of the plurality of battery cells;

calculating a second balancing time by multiplying a number of days of use of the battery pack to a value obtained by dividing a state of charge (SoC) deviation of the plurality of battery cells by the balancing capacity of the plurality of battery cells; and

calculating the first reference time by multiplying a first threshold value to a reference balancing time obtained by summing the first balancing time and the second balancing time.

9. The method of claim 8, wherein determining whether the battery pack is abnormal comprises:
determining the battery pack as an abnormal battery pack when the median exceeds the first reference time.

10. The method of claim 9, wherein the identifying the at least one abnormal battery cell comprises:

listing the plurality of battery cells based on a cumulative balancing time and extracting a plurality of battery cells within a threshold rank;

calculating a standard deviation of a cumulative balancing time of each of the plurality of battery cells within the threshold rank; and

calculating the second reference time by subtracting, from the median, a value obtained by multiplying a second threshold value to the standard deviation.

11. The method of claim 10, wherein identifying the at least one abnormal battery cell comprises:
diagnosing, when a cumulative balancing time of a first battery cell of the plurality of battery cells is less than the second reference time, a first battery cell as an abnormal battery cell.

12. A non-transitory computer readable storage medium storing instructions that, when executed by one or more processors, cause the one or more processors to perform:

comparing a median of a cumulative balancing time of each of a plurality of battery cells included in a battery pack to a first reference time;

determining, based on the comparison, whether the battery pack is abnormal, wherein the battery pack is abnormal when the median of the cumulative balancing time of each of the plurality of battery cells exceeds the first reference time;

identifying, based on determining the battery pack is abnormal, at least one abnormal battery cell of the plurality of battery cells based on determining the cumulative balancing time of the at least one abnormal battery cell is less than a second reference time; and

outputting a signal to a target device wherein the signal identifies the at least one abnormal battery cell.

13. The non-transitory computer readable storage medium of claim 12, wherein the instructions further cause the one or more processors to perform:
calculating the cumulative balancing time of each of the plurality of battery cells.

14. The non-transitory computer readable storage medium of claim 12, wherein the instructions further cause the one or more processors to perform:

calculating a first balancing time by dividing a capacity deviation of the plurality of battery cells by a balancing capacity of the plurality of battery cells;
calculating a second balancing time by multiplying a number of days of use of the battery pack by a value obtained by dividing a state of charge (SoC) deviation of the plurality of battery cells by the balancing capacity of the plurality of battery cells; and
calculating a first reference time by multiplying a first threshold value to a reference balancing time obtained by summing the first balancing time and the second balancing time.

15. The non-transitory computer readable storage medium of claim 14, wherein determining whether the battery pack is abnormal comprises:
determining the battery pack as an abnormal battery pack when the median exceeds the first reference time.

16. The non-transitory computer readable storage medium of claim 14, wherein the instructions further cause the one or more processors to perform:

listing the plurality of battery cells based on a cumulative balancing time and extract a plurality of battery cells having respective cumulative balancing times within a threshold rank;
calculating a standard deviation of a cumulative balancing time of each of the plurality of battery cells having respective cumulative balancing times within the threshold rank; and
calculating the second reference time by subtracting, from the median, a value obtained by multiplying a second threshold value to the standard deviation.

17. The non-transitory computer readable storage medium of claim 12, wherein identifying the at least one abnormal battery cell comprises:
diagnosing, when a cumulative balancing time of a first battery cell of the plurality of battery cells is less than the second reference time, a first battery cell as an abnormal battery cell.

18. The non-transitory computer readable storage medium of claim 12, wherein the instructions further cause the one or more processors to perform:
recording the cumulative balancing time in the memory by accumulating a balancing time of each of the plurality of battery cells.

1000

300

100

110

120

130

.
.
.

140

BATTERY
MANAGEMENT
APPARATUS
200

FIG.1

200

DATA
MANAGEMENT
UNIT
210

CONTROLLER
220

MEMORY
230

FIG.2

FIG.3

| TEMPERATURE / TIME | 0℃ | 25℃ | 40℃ | 60℃ |
|---|---|---|---|---|
| 0 DAY | 20.0 | 20.0 | 20.0 | 20.0 |
| 14 DAYS | 20.0 | 19.9 | 19.5 | 19.0 |
| 30 DAYS | 20.0 | 19.9 | 19.0 | 18.0 |
| 90 DAYS | 20.0 | 19.7 | 18.0 | 17.5 |

FIG.4A

| TEMPERATURE / TIME | 0℃ | 25℃ | 40℃ | 60℃ |
|---|---|---|---|---|
| 0 DAY | 50.0 | 50.0 | 50.0 | 50.0 |
| 14 DAYS | 49.8 | 49.8 | 49.5 | 49.0 |
| 30 DAYS | 49.5 | 49.5 | 48.0 | 48.0 |
| 90 DAYS | 49.0 | 49.0 | 47.0 | 46.0 |

FIG.4B

| TEMPERATURE / TIME | 0℃ | 25℃ | 40℃ | 60℃ |
|---|---|---|---|---|
| 0 DAY | 80.0 | 80.0 | 80.0 | 80.0 |
| 14 DAYS | 80.0 | 79.8 | 79.5 | 79.0 |
| 30 DAYS | 80.0 | 79.6 | 78.0 | 78.0 |
| 90 DAYS | 79.8 | 79.2 | 77.0 | 76.0 |

FIG.4C

| BATTERY CELL CHARACTERISTIC DATA | |
|---|---|
| BATTERY CELL CAPACITY [Ah] | 50 |
| BATTERY CELL CAPACITY DEVIATION [Ah] | 1 |
| BATTERY CELL CAPACITY DEVIATION [%] | 2 |
| BALANCING CURRENT [mA] | 50 |
| BATTERY CELL BALANCING CAPACITY [Ah/day] | 1.2 |
| BATTERY CELL BALANCING CAPACITY [%/day] | 2.4 |

FIG.5A

| BATTERY CELL USE DATA | |
|---|---|
| BATTERY PACK USE DAY [day] | 365 |
| BATTERY CELL AVERAGE TEMPERATURE [℃] | 40 |
| BATTERY CELL AVERAGE SOC [%] | 80 |
| SELF-DISCHARGE RATE [%/30day] | 2 |
| SELF-DISCHARGE RATE DEVIATION [%] | 10 |
| SOC DEVIATION CAUSED BY SELF-DISCHARGE RATE [%/day] | 0.00667 |

FIG.5B

FIG.6

START

CALCULATE CUMULATIVE BALANCING TIME OF EACH OF PLURALITY OF BATTERY CELLS INCLUDED IN BATTERY PACK —S101

CALCULATE MEDIAN OF CUMULATIVE BALANCING TIME OF EACH OF PLURALITY OF BATTERY CELLS —S102

DETERMINE WHETHER BATTERY PACK IS ABNORMAL BY COMPARING MEDIAN WITH FIRST REFERENCE TIME —S103

DIAGNOSE AT LEAST ONE OF PLURALITY OF BATTERY CELLS BY COMPARING CUMULATIVE BALANCING TIME OF EACH OF PLURALITY OF BATTERY CELLS WITH SECOND REFERENCE TIME WHEN MEDIAN EXCEEDS FIRST REFERENCE TIME —S104

END

FIG.7

2000

MEMORY ~2200

COMMUNICATION I/F ~2400

MCU ~2100

INPUT/OUTPUT I/F ~2300

FIG.8

## INTERNATIONAL SEARCH REPORT

| International application No. |
| --- |
| **PCT/KR2023/021025** |

**A. CLASSIFICATION OF SUBJECT MATTER**

**B60R 16/033**(2006.01)i; **B60R 16/023**(2006.01)i; **H01M 10/48**(2006.01)i; **H02J 7/00**(2006.01)i

According to International Patent Classification (IPC) or to both national classification and IPC

**B. FIELDS SEARCHED**

Minimum documentation searched (classification system followed by classification symbols)

B60R 16/033(2006.01); B60L 11/18(2006.01); B60L 3/00(2006.01); B60L 58/22(2019.01); G01R 31/36(2006.01); H01M 10/48(2006.01); H02J 7/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리 팩(battery pack), SOC(state of charge), 저전압(under voltage), 자가방전 (self-discharge), 메모리(memory)

**C. DOCUMENTS CONSIDERED TO BE RELEVANT**

| Category* | Citation of document, with indication, where appropriate, of the relevant passages | Relevant to claim No. |
| --- | --- | --- |
| X | KR 10-2021-0041981 A (LG CHEM, LTD.) 16 April 2021 (2021-04-16)<br>See paragraphs [0034], [0039], [0040], [0045] and [0052] and figures 1 and 3-5. | 1,2,12,13,17 |
| Y | | 3,6,7,18 |
| A | | 4,5,8-11,14-16 |
| Y | US 2020-0006958 A1 (FORD GLOBAL TECHNOLOGIES, L.L.C.) 02 January 2020 (2020-01-02)<br>See paragraphs [0011] and [0117], claim 17 and figure 1. | 3,6,7,18 |
| A | JP 2010-032412 A (SANYO ELECTRIC CO., LTD.) 12 February 2010 (2010-02-12)<br>See claims 1 and 6 and figures 1 and 2. | 1-18 |
| A | KR 10-2021-0050396 A (LG CHEM, LTD.) 07 May 2021 (2021-05-07)<br>See claims 11-13 and figure 4. | 1-18 |

☑ Further documents are listed in the continuation of Box C.  ☑ See patent family annex.

| | | |
| --- | --- | --- |
| * | Special categories of cited documents: | |
| "A" | document defining the general state of the art which is not considered to be of particular relevance | |
| "D" | document cited by the applicant in the international application | |
| "E" | earlier application or patent but published on or after the international filing date | |
| "L" | document which may throw doubts on priority claim(s) or which is cited to establish the publication date of another citation or other special reason (as specified) | |
| "O" | document referring to an oral disclosure, use, exhibition or other means | |
| "P" | document published prior to the international filing date but later than the priority date claimed | |

"T" later document published after the international filing date or priority date and not in conflict with the application but cited to understand the principle or theory underlying the invention

"X" document of particular relevance; the claimed invention cannot be considered novel or cannot be considered to involve an inventive step when the document is taken alone

"Y" document of particular relevance; the claimed invention cannot be considered to involve an inventive step when the document is combined with one or more other such documents, such combination being obvious to a person skilled in the art

"&" document member of the same patent family

| Date of the actual completion of the international search | Date of mailing of the international search report |
| --- | --- |
| **29 March 2024** | **29 March 2024** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

| International application No. |
| --- |
| **PCT/KR2023/021025** |

| C. | DOCUMENTS CONSIDERED TO BE RELEVANT | |
| --- | --- | --- |
| Category* | Citation of document, with indication, where appropriate, of the relevant passages | Relevant to claim No. |
| A | KR 10-2022-0049255 A (LG ENERGY SOLUTION, LTD.) 21 April 2022 (2022-04-21)<br>See claims 1 and 2 and figure 2. | 1-18 |

Form PCT/ISA/210 (second sheet) (July 2022)

**INTERNATIONAL SEARCH REPORT**
Information on patent family members

International application No.

**PCT/KR2023/021025**

| Patent document cited in search report | | | Publication date (day/month/year) | Patent family member(s) | | | Publication date (day/month/year) |
|---|---|---|---|---|---|---|---|
| KR | 10-2021-0041981 | A | 16 April 2021 | None | | | |
| US | 2020-0006958 | A1 | 02 January 2020 | CN | 110654267 | A | 07 January 2020 |
| | | | | DE | 102019117434 | A1 | 02 January 2020 |
| | | | | US | 10992145 | B2 | 27 April 2021 |
| JP | 2010-032412 | A | 12 February 2010 | None | | | |
| KR | 10-2021-0050396 | A | 07 May 2021 | None | | | |
| KR | 10-2022-0049255 | A | 21 April 2022 | None | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230180590
- KR 1020220178734